# EUROPEAN PATENT APPLICATION

(11) **EP 4 109 563 A1**
(43) Date of publication of application: **28.12.2022**
(21) Application number: 21757982.0
(22) Date of filing: 05.02.2021
(51) Int. Cl.: H01L 31/18, H01L 31/05

(54) **METHOD FOR MANUFACTURING SOLAR CELL MODULE**

(30) Priority: 18.02.2020 JP 2020025534
(71) Applicant: Panasonic Holdings Corporation, Osaka 571-8501 (JP)
(72) Inventor: MAKI, Kenichi, Osaka-shi, Osaka 540-6207 (JP); HASHIMOTO, Haruhisa, Osaka-shi, Osaka 540-6207 (JP); SUMITOMO, Koutarou, Osaka-shi, Osaka 540-6207 (JP); KANNO, Hiroshi, Osaka-shi, Osaka 540-6207 (JP)
(74) Representative: Müller-Boré & Partner Patentanwälte PartG mbB
(86) International application number: PCT/JP2021/004359
(87) International publication number: WO 2021/166693

(57) **Abstract**

This method for manufacturing a solar cell module comprises a step for applying an adhesive to a first adhesion region (31) so that the first adhesion region (31) and a second adhesion region (33) are disposed alternately on a light receiving surface of a solar cell (11) along a first direction, and a step for arranging a light receiving surface-side wiring material (15) along the first direction on the light receiving surface side of the solar cell (11) to which the adhesive has been applied. The step for arranging the light receiving surface-side wiring material (15) comprises arranging the light receiving surface-side wiring material (15), which has a holding region and a non-holding region aligned along the first direction, in the first adhesion region (31) and the second adhesion region (33) of the solar cell (11) so that, in a state in which a first holder is in contact with the holding region of the light receiving surface-side wiring material (15), the second adhesion region (33) and the holding region overlap each other.

## Description

### TECHNICAL FIELD

The present invention relates to a method of manufacturing a solar cell module.

### BACKGROUND

A solar cell module includes a plurality of solar cells, wiring materials connecting the solar cells, and fillers that seal these members, for example. The wiring materials are attached on electrodes of the solar cells, typically with solder. However, soldering may thermally affect the solar cells to thereby generate warps and cracks in the solar cells. These defects are more significant in thinner solar cells. To address these defects, methods for bonding the wiring materials and the solar cell using a resin adhesive (hereinafter referred to simply as an "adhesive") in place of solder have been proposed (see Patent Document 1, for example).

### CITATION LIST

### PATENT LITERATURE

[PATENT DOCUMENT 1] WO 2014/132575

### SUMMARY

### [TECHNICAL PROBLEM]

To attach the wiring materials on respective opposite faces of the solar cell using an adhesive, in Patent Document 1, an adhesive is applied to bus bar electrodes disposed on each of the opposite faces of the solar cell along the longitudinal direction of the bus bar electrodes, and after application of the adhesive, the wiring materials are attached, through thermocompression bonding, to the solar cell to which the adhesive is applied. At this time, the wiring material may be moved to the solar cell while being held by a holder having a suction mechanism that sucks the outside air. However, in disposing the wiring material on the solar cell via the adhesive, the adhesive having high fluidity prior to curing can flow from between the solar cell and the thin wiring material toward the holder and adhere in suction holes of the holder. This contaminates the suction holes of the holder, resulting in the increased frequency of cleaning of the holder or in deterioration of the suction force of the holder to let the wiring material fall off. Preventing adhesion of the adhesive to the holder that holds the wiring material is therefore a significant goal to be achieved in a manufacturing method for solar cell modules.

### [SOLUTION TO PROBLEM]

In accordance with an aspect of the invention, a solar cell module manufacturing method comprises the step of preparing a solar cell having a light receiving face and a back face and including current collecting electrodes on each of the light receiving face and the back face, applying an adhesive in first adhesion regions on the light receiving face of the solar cell such that the first adhesion regions and second adhesion regions are alternatively arranged along a first direction, and applying an adhesive in third adhesion regions on the back face of the solar cell such that the third adhesion regions and fourth adhesion regions are alternatively arranged along the first direction, disposing light receiving face wiring materials over the light receiving face of the solar cell to which the adhesive is applied, along the first direction, disposing back face wiring materials over the back face of the solar cell to which the adhesive is applied, along the first direction, and heating or pressing the solar cell on which the light receiving face wiring materials and the back face wiring materials are disposed in directions from both the light receiving face and the back face to attach the light receiving face wiring materials and the back face wiring materials. The light receiving face wiring materials each include holder regions and non-holder regions arranged along the first direction, and the step of disposing the light receiving face wiring materials includes bringing a first holder into contact with the holder regions of the light receiving face wiring materials, and, in this state, disposing the light receiving face wiring materials on the first adhesion regions and the second adhesion regions on the solar cell such that the second adhesion regions and the holder regions overlap. The back face wiring materials each include holder regions and non-holder regions arranged along the first direction, and the step of disposing the back face wiring materials includes bringing a second holder into contact with the holder regions of the back face wiring materials, and, in this state, disposing the back face wiring materials on the third adhesion regions and the fourth adhesion regions on the solar cell such that the fourth adhesion regions and the holder regions overlap.

### [ADVANTAGEOUS EFFECTS OF INVENTION]

The present invention optimizes the application state of an adhesive to thereby prevent adhesion of the adhesive to a holder that holds wiring materials.

### BRIEF DESCRIPTION OF DRAWINGS

FIG. 1 is a cross sectional view of a solar cell module manufactured with a manufacturing method according to an example embodiment of the present invention.
FIG. 2A is a diagram (front view) illustrating a solar cell forming the solar cell module of FIG. 1, viewed from a light receiving face side.
FIG. 2B is a diagram (rear view) illustrating a solar cell forming the solar cell module of FIG. 1, viewed from a rear face side.
FIG. 3 is a flowchart showing an adhesive applying step and a wiring material fixing step in a method of manufacturing a solar cell module according to an example embodiment of the present invention.
FIG. 4 is a diagram illustrating a wiring material arranging step that is part of the wiring material fixing step in the manufacturing method including the adhesive applying step and the wiring material fixing step indicated in FIG. 3.
FIG. 5(a) illustrates the solar cell to which an adhesive has been applied during the adhesive applying step in FIG. 3, viewed from the light receiving face side; FIG. 5(b) is an enlarged view of a portion A in FIG. 5(a); and FIG. 5(c) is an enlarged view of a portion B in FIG. 5(b).
FIG. 6 is a diagram corresponding to a C-C cross section of FIG. 5(b), illustrating a method of temporarily pressure-bonding the wiring materials to the opposite faces of the solar cell to which an adhesive has been applied during the wiring material fixing step in FIG. 3.
FIG. 7 is a diagram corresponding to a D-D cross section of FIG. 5(b), illustrating a method of temporarily pressure-bonding the wiring materials to the opposite faces of the solar cell to which an adhesive has been applied during the wiring material fixing step in FIG. 3.
FIG. 8 is a diagram schematically illustrating a state immediately before performing heating and pressing the two solar cells by first and second heating and pressing devices in directions from the respective opposite sides in the first attaching step and the second attaching step in FIG. 3.
FIG. 9 is an enlarged perspective view of a portion E in FIG. 8.
FIG. 10 is a diagram schematically illustrating a state where heating and pressing of the two solar cells is being performed by the first and second heating and pressing devices in directions from the respective opposite sides in the first attaching step and the second attaching step in FIG. 3.
FIG. 11 is a diagram corresponding to a C-C cross section in FIG. 5(b), for explaining advantages of the embodiment of the present invention: FIG. 11 (a) illustrates a reference example in which the interval D1 between adhesives of adjacent first adhesion regions in the solar cell is smaller than the interval D2 of finger electrodes or adjacent current collecting electrodes, and FIG. 11 (b) illustrates the embodiment in which the interval D1 is larger than the interval D2.
FIG. 12 is a diagram corresponding to FIG. 5(b) in a manufacturing method of a solar cell module according to a comparative example.
FIG. 13 is a diagram corresponding to FIG. 6 in the manufacturing method of a solar cell module according to the comparative example.
FIG. 14 is a diagram corresponding to FIG. 7 in the manufacturing method of a solar cell module according to the comparative example.
FIG. 15 illustrates application states of the adhesive to a light receiving face of a solar cell in four further examples of the embodiment of the present invention.
FIG. 16 illustrates fixing states of the wiring materials to the light receiving face of a solar cell in the four further examples of the embodiment of the present invention.
FIG. 17 illustrate application states of an adhesive to a light receiving face of a solar cell in two further examples of the embodiment of the present invention.

### DESCRIPTION OF EMBODIMENTS

Embodiments of the present disclosure will be described in detail below by reference to the drawings. The drawings referred to in the embodiments are schematically described, and elements in the drawings may have dimensional ratios that are different from actual dimensional ratios. Specific dimensional ratios, for example, should be determined in consideration of the following description.

In the specification, a "light receiving face" refers to a face where the sunlight enters externally of a solar cell. A "back face" refers to a face opposite the light receiving face. More specifically, over 50% to 100% of the sunlight entering the solar cell has entered through the light receiving face. The term "above" refers to above in the vertical direction unless otherwise specified. Regarding the term "substantially", in the language "substantially the same", for example, this can mean both completely the same and also essentially the same.

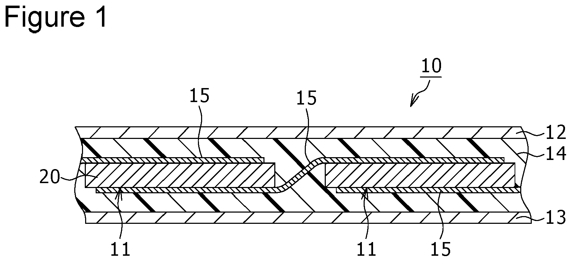

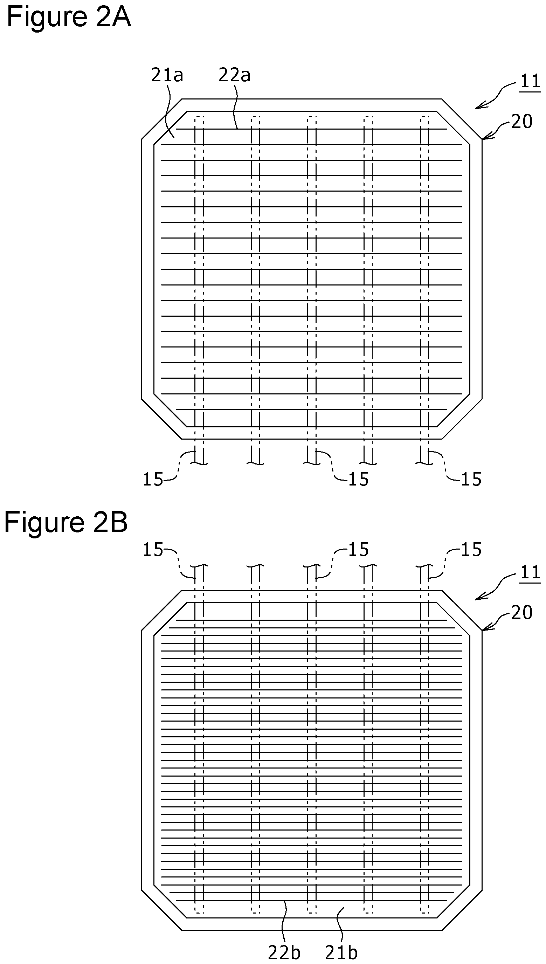

FIG. 1 is a cross sectional view of a solar cell module 10 according to an example embodiment of the present invention. FIGs. 2A and 2B illustrate a solar cell 11 forming the solar cell module 10, viewed from the light receiving face side and the back face side, respectively (in which wiring materials 15 are shown in dashed and double-dotted lines). The solar cell module 10 which will be described with reference to FIG. 1 and FIGs. 2A and 2B is an example product manufactured by the method described below. In the following, a configuration of the solar cell 11 having no bus bar electrodes on either side will be described; however, the bus bar electrodes may be disposed on the opposite faces of the solar cell 11 so as to intersect finger electrodes 22a and 22b at substantially a right angle.. The bus bar electrodes collect carriers from the finger electrodes 22a and 22b. In such a configuration, to fix the wiring materials 15 to the bus bar electrodes, an adhesive for fixing the wiring materials 15 to the solar cell 11 may be applied to portions of the opposite faces of the solar cell 11 where the bus bar electrodes are to be disposed.

As illustrated in FIG. 1, the solar cell module 10 includes a plurality of solar cells 11, a first protective member 12 disposed adjacent to the light receiving face of the solar cell 11, and a second protective member 13 disposed adjacent to the back face of the solar cell 11. The plurality of solar cells 11 are sandwiched between the protective members 12 and 13, and are also sealed with a filler 14 such as ethylene-vinyl acetate copolymer (EVA). The protective members 12 and 13 may be a transparent member such as a glass substrate and resin substrate, or a resin film. In a configuration in which light entering through the back face is not assumed, the protective member 13 may be a member that is not transparent. The solar cell module 10 further includes the wiring materials 15 electrically connecting the solar cells 11, and frames and a terminal box which are not shown, for example.

The solar cell 11 includes a photoelectric converter 20 configured to receive sunlight and generate carriers. The photoelectric converter 20 includes, for example, a semiconductor substrate such as crystalline silicon (c-Si), gallium arsenide (GaAs), and indium phosphide (InP), for example, and an amorphous semiconductor layer on the substrate. The photoelectric converter 20 may preferably include transparent conductive layers 21a and 21b on the amorphous semiconductor layer. In a specific example configuration, an i-type amorphous silicon layer, a p-type amorphous silicon layer, and the transparent conductive layer 21a are sequentially formed on a light receiving face of an n-type single crystal silicon layer, and an i-type amorphous silicon layer, an n-type amorphous silicon layer, and the transparent conductive layer 21b are sequentially formed on the back face. The transparent conductive layers 21a and 21b may preferably be a transparent conductive oxide obtained by doping tin (Sn) or antimony (Sb), for example, into a metal oxide such as indium oxide (In₂O₃) and zinc oxide (ZnO), for example.

As illustrated in FIGs. 2A and 2B, preferably, finger electrodes 22a are disposed on the photoelectric converter 20 as light receiving face current collecting electrodes and finger electrodes 22b are disposed on the photoelectric converter 20 as back face current collecting electrodes, respectively. The finger electrodes 22a and 22b are thin linear electrodes disposed over a wide range on the transparent conductive layers 21a and 21b, respectively.

In the present embodiment, the linear finger electrodes 22a and 22b are disposed in great number at predetermined intervals. The back face current collecting electrodes and the light receiving face current collecting electrodes have similar electrode arrangement. However, as the photoelectric conversion performance is less affected by the light shielding loss on the back face than on the light receiving face, the back face current collecting electrodes may be disposed on a larger area than that of the light receiving face current collecting electrodes. For example, the back face current collecting electrodes have an electrode area twice to six times as large as the electrode area of the light receiving face current collecting electrodes to thereby increase the number of finger electrodes 22b with respect to the number of finger electrodes 22a. As such, the "light receiving face" may be referred to as a face having a smaller electrode area and the "back face" as a face having a larger electrode area.

The current collecting electrode has a structure including a conductive filler such as silver (Ag) dispersed in a binder resin, for example. The current collecting electrode having this structure may be formed by screen printing, for example.

The wiring material 15 is an elongated member that connects the solar cells 11 adjacently disposed. The wiring material 15 has a substantially circular cross section, but may also have a substantially rectangular cross section. To reduce portions on the surface of the solar cell 11 to be shaded by the wiring material 15 and increase the output of the solar cell module 10, the wiring material 15 having a substantially circular cross section is preferred. However, the wiring material 15 having a substantially circular cross section may suffer from the following disadvantage. As will be described below, in attaching the wiring material 15 to the solar cell 11, the adhesive squeezed out from between the solar cell 11 and the wiring material 15 sucks in the outside air through a suction hole and is likely to flow toward the holder that holds the wiring material 15 during temporary pressure bonding of the wiring material 15. This is disadvantageous in terms of reduction of contamination in the suction holes of the holder. In the present embodiment, as will be described below, contamination in the suction holes in such a configuration can be reduced, and so this advantage of reduction in the contamination is remarkable for the wiring materials 15 having a substantially circular cross section.

The wiring material 15 has a first end to be attached, via an adhesive, to the light receiving face of one of a pair of the solar cells 11 adjacently disposed side by side. The wiring material 15 also has a second end to be attached, via an adhesive, to the back face of the other solar cell 11 of the pair of adjacently disposed solar cells 11. More specifically, the wiring material 15 is bent in the thickness direction of the solar cell module 10 between a pair of adjacently disposed solar cells 11 to serially connect these solar cells 11. The wiring material 15 is attached to the adjacently disposed solar cells 11 so as to intersect and contact the plurality of finger electrodes 22a and 22b.

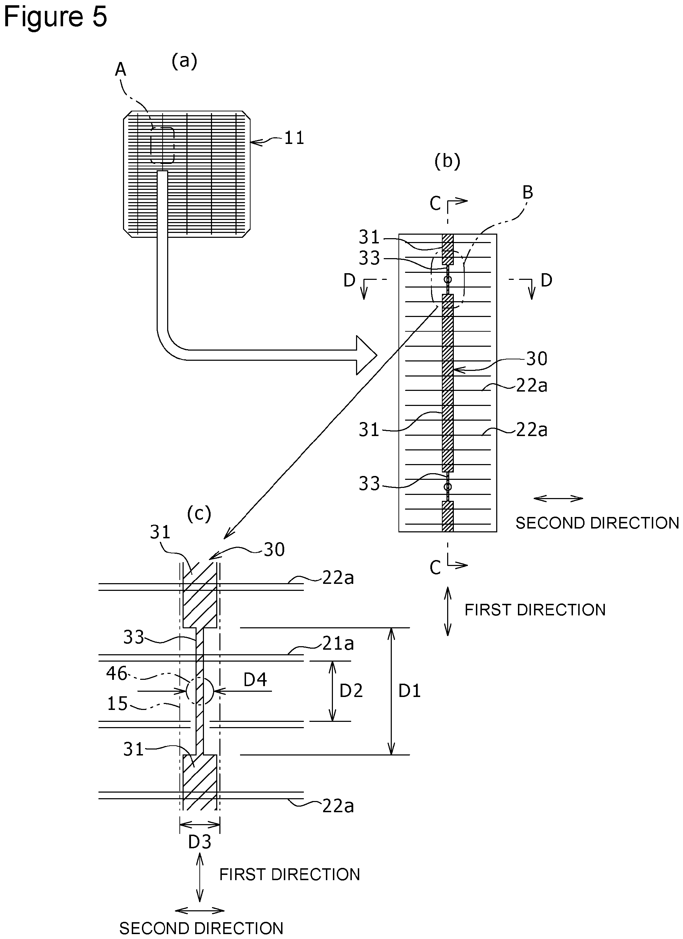

The adhesive 30 (FIG. 5) may include a thermoplastic adhesive or a thermosetting adhesive, a cold setting adhesive (moisture curing adhesive, two-part adhesive), and an energy ray curing adhesive (ultraviolet curing adhesive). Among these adhesives, curable adhesives are preferable, and thermosetting adhesive is particularly preferable. The thermosetting adhesive may include, for example, a urea-based adhesive, a resorcinolbased adhesive, a melamine-based adhesive, a phenolic adhesive, an epoxy-based adhesive, a polyurethane-based adhesive, a polyester-based adhesive, a polyimide-based adhesive, and an acrylic adhesive.

The adhesive 30 may contain a conductive filler such as Ag particles. However, in terms of the manufacturing cost and reduction in the light shielding loss, for example, a non-conductive thermosetting adhesive containing no conductive filler is preferably used. The adhesive 30 before curing is in a liquid state. The "liquid state" refers to a state having fluidity at normal temperatures (25°C), and includes a paste state. The adhesive 30 has a viscosity of 1 Pa•s to 50 Pa•s. The manufacturing method described below is particularly suitable for the adhesive 30 having low viscosity and high fluidity, for example.

Preferably, the adhesive 30 is applied only between the wiring material 15 and the light receiving face, and between the wiring material 15 and the back face. More specifically, the adhesive 30 is preferably applied at a width that is not greater than the width of spaces between the wiring material 15 and the light receiving face and between the wiring material 15 and the back face, respectively. In the present embodiment, particularly, the application state of the adhesive 30 can be optimized to reduce adhesion of the adhesive 30 squeezed out from the wiring material 15 to the holder that holds and moves the wiring material 15 to fix the wiring material 15 to the solar cell 11.

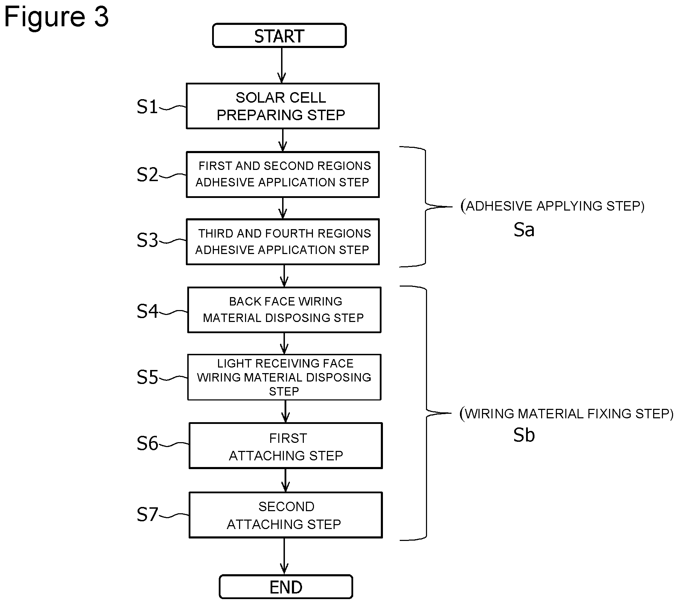

Referring to FIG. 3 to FIG. 10, the manufacturing method of the solar cell module 10 according to an example embodiment of the present invention will be described in detail. FIG. 3 is a flowchart showing an adhesive applying step and a wiring material fixing step in the manufacturing method of the solar cell module 10 according to the embodiment.

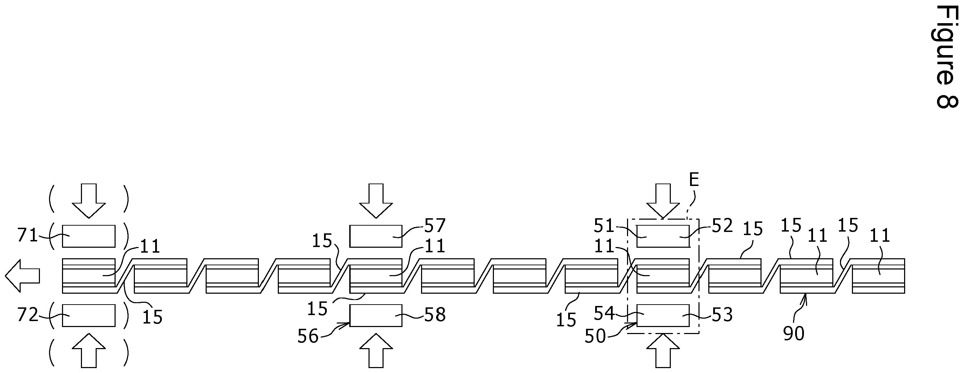

As illustrated in FIG. 3, the manufacturing method according to the embodiment includes a solar cell providing step S1, the adhesive applying step Sa, and the wiring material fixing step Sb. The solar cell providing step S1 is a process step of providing a plurality of solar cells 11 forming a string 90 (FIG. 8), which will be described below, that constitutes the solar cell module 10. Each of these solar cells 11 includes the finger electrodes 22a and 22b, or the current collecting electrodes, on the light receiving face and the back face, respectively, as illustrated in FIG. 2A and FIG. 2B. Each of the solar cells 11 may include the finger electrodes 22a and 22b so as to intersect the bus bar electrodes that are further current collecting electrodes on the light receiving face and the back face, respectively. The bus bar electrodes are disposed outside the finger electrodes 22a and 22b.

The adhesive applying step Sa includes a first and second regions adhesive applying step S2 and a third and fourth regions adhesive applying step S3. In the first and second regions adhesive applying step S2, as will be described below, the adhesive 30 (FIG. 5) is applied to a first adhesion region and a second adhesion region alternately disposed along a first direction that is a direction in which the wiring materials 15 extend on the light receiving face of the solar cell 11. In the third and fourth regions adhesive applying step S3, as will be described below, the adhesive 30 (FIG. 5) is applied to a third adhesion region and a fourth adhesion region alternately disposed along the first disposing direction on the back face of the solar cell 11.

The wiring material fixing step Sb includes a back face wiring material disposing step S4, a light receiving face wiring material disposing step S5, a first attaching step S6, and a second attaching step S7. In the back face wiring material disposing step S4, the wiring materials 15 are disposed, via the adhesive 30, on the back face of the solar cell 11. In the light receiving face wiring material disposing step S5, the wiring materials 15 are disposed, via the adhesive 30, on the light receiving face of the solar cell 11. In the first attaching step S6, the solar cell 11 on which the wiring materials 15 are disposed is heated and pressed in directions from both sides of the light receiving face and the back face to enhance the bonding strength of the wiring material 15 with the solar cell 11. In the second attaching step S7, subsequent to the first attaching step S6, the solar cell 11 on which the wiring materials 15 are disposed is heated and pressed in directions from both sides of the light receiving face and the back face to further enhance the bonding strength of the wiring material 15 with the solar cell 11. At this time, the bonding strength between the solar cell 11 and the wiring material 15 on the light receiving face prior to the second attaching step S7 is smaller than the bonding strength between the solar cell 11 and the wiring material 15 on the light receiving face after the second attaching step S7. Among the steps described above, the adhesive applying step Sa and the wiring material fixing step Sb will be particularly described in detail below.

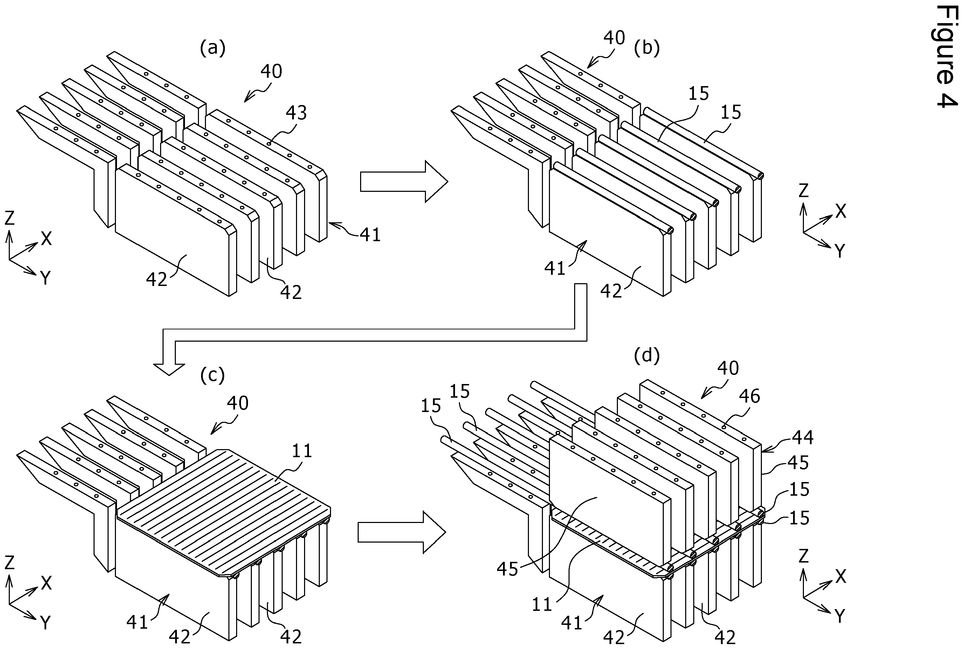

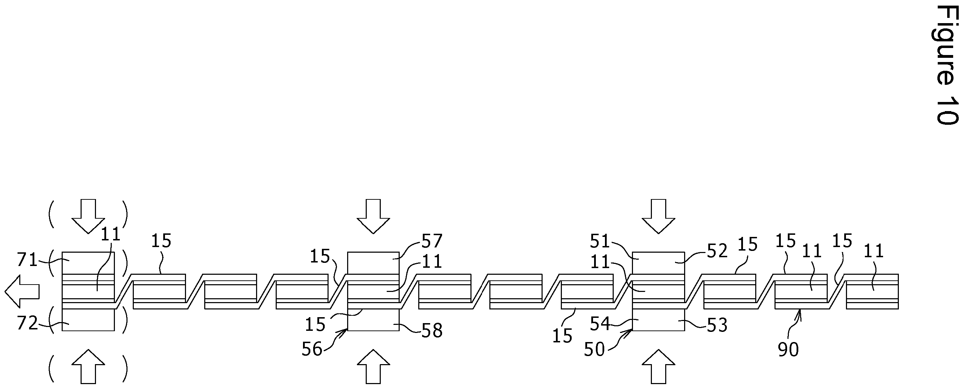

The solar cell module 10 can be manufactured by a manufacturing line including a wiring material connecting system 40 (FIG. 4). The wiring material connecting system 40, which partially constitutes the manufacturing line of the solar cell module 10, disposes the wiring materials 15 on the back face and the light receiving face of the solar cell 11 via the adhesive 30 (FIG. 5). The wiring material connecting system 40 attaches the wiring materials 15 to the solar cell 11 to which the adhesive 30 has been applied, to produce the string 90 (see FIGs. 8 and 10) including a plurality of solar cells 11 connected via the wiring materials 15. The string 90 is transported to a laminator (not shown), for example, where a lamination step which will be described below is performed to produce the solar cell module 10.

FIG. 4 illustrates the wiring material disposing steps S4 and S5 that are part of the wiring material fixing step Sb in the manufacturing method including the adhesive applying step Sa and the wiring material fixing step Sb illustrated in FIG. 3. The wiring material connecting system 40 includes a lower stage 41 on which the solar cell 11 and the wiring materials 15 on the back face (the lower side in FIGs. 4(c) and 4(d)) are placed. The lower stage 41 corresponds to a second holder. The lower stage 41 includes a plurality of plates 42 extending in the longitudinal direction Y of the wiring materials 15 to be disposed on the back face of the solar cell 11, in the number corresponding to the number of wiring materials 15 on the back face. The plurality of plates 42 are arranged at intervals along the arranging direction of the wiring materials 15. In FIG. 4, the direction along the thickness of the plates 42 is indicated with X, the longitudinal direction is indicated with Y, and the vertical direction orthogonal to the directions X and Y is indicted with Z. Each of the plates 42 includes a plurality of suction holes 43 (FIG. 4(a)) extending in the vertical direction Z through the plates 42 and disposed at intervals along the longitudinal direction Y. The lower stage 41 further includes a first suction device (not shown) connected to the suction holes 43. The first suction device is a mechanism that sucks the outside air in through the suction holes 43 and may include an air outlet, for example. The lower stage 41 thus sucks the wiring materials 15 disposed above with the plurality of suction holes 43 to thereby hold the wiring materials 15 on the lower stage 41.

The wiring material connecting system 40 further includes an upper stage 44 that holds the wiring materials 15 on the light receiving face (upper side in FIG. 4(d)). The upper stage 44 corresponds to a first holder. The upper stage 44 includes a plurality of plates 45 extending in the longitudinal direction Y of the wiring materials 15 to be disposed on the light receiving face of the solar cell 11, in a number corresponding to the number of wiring materials 15 on the light receiving face. The plurality of plates 45 are arranged at intervals along the arranging direction X of the wiring materials 15. The plates 42 on the back face and the plates 45 on the light receiving face are disposed at the same locations in the thickness direction X. Each of the plates 45 on the light receiving face, similar to the plates 42 on the back face, includes a plurality of suction holes 46 extending in the vertical direction Z through the plates 45 and disposed at intervals along the longitudinal direction Y. The upper stage 44 further includes a second suction device (not shown) connected to the suction holes 46. The second suction device is a mechanism that sucks the outside air in through the suction holes 46 and may include an air outlet, for example. The upper stage 44 thus sucks the wiring materials 15 disposed below with the plurality of suction holes 46 to thereby hold the wiring materials 15 on the upper stage 41. The first suction device and the second suction device may be a common single suction device. The plates 45 on the upper stage 44 are moved vertically by a mover (not shown).

Prior to the back face wiring material disposing step S4 (FIG. 3), the wiring material 15 is placed on each plate 42 of the lower stage 41 and is sucked and held by each plate 42, as illustrated in FIG.4(a) and FIG. 4(b). FIG. 4(b) illustrates only portions of the wiring materials 15 that are disposed on the plates 42. The first and second region adhesive applying step S2 is performed prior to the step shown in FIG. 4(c). Specifically, as illustrated in FIG. 4(c), prior to disposing the solar cell 11 on the back face wiring materials 15, the first and second regions adhesive applying step of applying the adhesive 30 (FIG. 5) on the light receiving face solar cell 11 is performed, and the third and fourth regions adhesive applying step S3 of applying the adhesive 30 to the back face of the solar cell 11 is performed. While in FIG. 3 the third and fourth regions adhesive applying step S3 is performed after the first and second regions adhesive applying step S2, the third and fourth regions adhesive applying step may be performed before the first and second regions adhesive applying step.

FIG. 5(a) illustrates the solar cell 11 to which the adhesive 30 has been applied in the adhesive applying step Sa in FIG. 3, viewed from the light receiving face side; FIG. 5(b) is an enlarged view of a portion A in FIG. 5(a); and FIG. 5(c) is an enlarged view of a portion B in FIG. 5(b). In the first and second regions adhesive applying step S2, the adhesive 30 is applied to the first adhesion region 31 and the second adhesion region 33 on the light receiving face of the solar cell 11 such that the first adhesion region 31 and the second adhesion region 33 are alternately arranged in the first direction (that is a vertical direction in FIGs. 5(a) to 5(c)). The first direction is along the plane of the solar cell 11 and intersects the finger electrodes 22a at a substantially right angle. The first adhesion region 31 has a larger width in the second direction (that is a horizontal direction in FIGs. 5(a) to 5(c)) in an adhesion allowable region, in which the adhesive 30 can be applied, than the second adhesion region 33. The second direction is along the plane of the solar cell 11 and orthogonal to the first direction. Both the first adhesion region 31 and the second adhesion region 33 have a substantially rectangle shape elongated in the first direction when viewed from the direction orthogonal to the light receiving face. In this example, the first adhesion region 31 and the second adhesion region 33 together cover the entire adhesion allowable region to which the adhesive 30 is to be applied. The first adhesion region 31 and the second adhesion region 33 therefore include the adhesive 30 of the first adhesion region 31 having a larger width in the second direction, and the adhesive 30 of the second adhesion region 33 having a smaller width in the second direction, which are arranged alternately along the first direction. In the present specification, the "adhesion region" refers to the adhesion allowable region of the adhesive 30. In each "adhesion region", the adhesive may be disposed separately along the first direction, in at least one location in the middle of the first direction.

In the first and second regions adhesive applying step S2, the adhesive 30 is applied to each of the first adhesion regions 31 and each of the second adhesion regions 33 on the light receiving face of the solar cell 11 so as to extend across the plurality of finger electrodes 22a. At this time, assuming that the interval between the adhesives 30 in the first adhesion regions 31 adjacent in the first direction is D1, and the interval between two adjacent finger electrodes 22a including at least one finger electrode 22a between the two adhesives 30 is D2, as illustrated in FIG. 5(c), the relationship of Dl > D2 is satisfied. Assuming further that the width of the wiring material 15 on the light receiving face in the longitudinal direction of the finger electrode 22a is D3, and the major axis or the maximum width of the suction hole 46 of the upper stage 44 that sucks the wiring material 15 on the light receiving face (that is a diameter of the suction hole 46 having a perfect circle cross section) is D4, the relationship of Dl > D2 > D3 > D4 is satisfied.

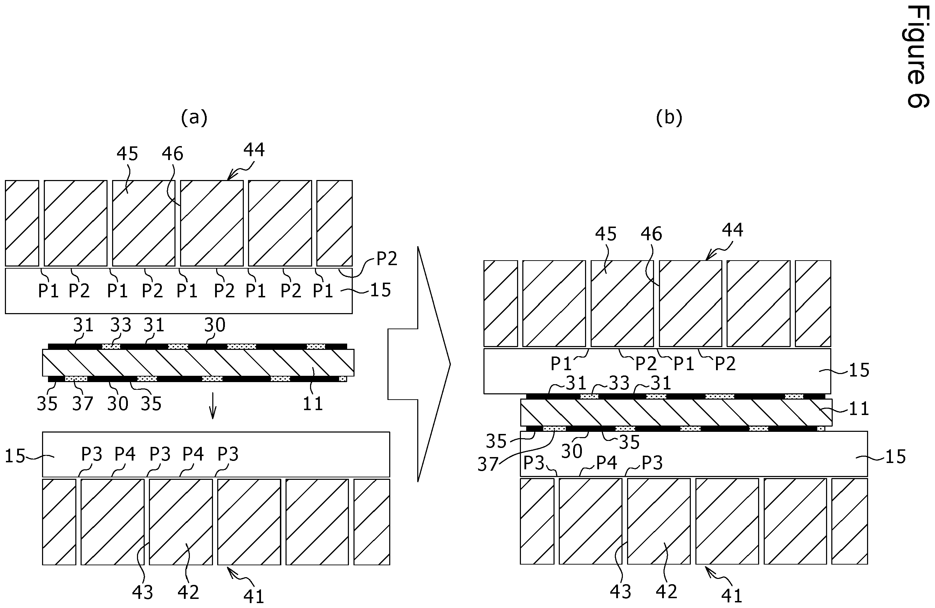

In the third and fourth regions adhesive applying step S3 (FIG. 3), the adhesive 30 is applied to the third adhesion regions 35 and the fourth adhesion regions 37 on the back face (the lower side in FIG. 6) of the solar cell 11 such that the third adhesion regions 35 and the fourth adhesion regions 37 are arranged alternately in the first direction (the horizontal direction in FIG. 6). FIG. 6, which will be described below, shows the first adhesion regions 31 and the third adhesion regions 35 as solid portions and shows the second adhesion regions 33 and the fourth adhesion regions 37 as dotted portions. The third adhesion region 35 has a larger width in the adhesion allowable region in which the adhesive 30 can be applied along the second direction (the direction orthogonal to the plane of FIG. 6) than the fourth adhesion region 37. Both the third adhesion region 35 and the fourth adhesion region 37, similar to the adhesive 30 on the light receiving face in FIG. 5(b), have a substantially rectangular shape elongated in the first direction when viewed from the direction orthogonal to the back face. In the present example, the third adhesion regions 35 and the fourth adhesion regions 37 together cover the entire adhesion allowable region to which the adhesive 30 is to be applied.

In the third and fourth regions adhesive applying step S3, the adhesive 30 is applied to each of the third adhesion regions 35 and each of the fourth adhesion regions 37 on the back face of the solar cell 11 so as to extend across the plurality of finger electrodes 22b (See FIG. 2B). At this time, assuming that the interval between the adhesives 30 in the third adhesion regions 35 adjacent in the first direction (the horizontal direction in FIG. 6) is D1a, and the interval between two adjacent finger electrodes 22b including at least one finger electrode 22b between the two adhesives 30 is D2a, the relationship of Dla > D2a is satisfied. Assuming further that the width of the wiring material 15 on the back face in the longitudinal direction of the finger electrode 22b is D3a, and the major axis or the maximum width of the suction hole 43 of the lower stage 41 that sucks the wiring materials 15 on the back face (FIGs. 4 and 6) is D4a, the relationship of D1a > D2a > D3a > D4 is satisfied.

In the first and second regions adhesive applying step S2 and the third and fourth regions adhesive applying step S3, the adhesive 30 may be applied by any of screen printing, a dispenser, and a spray. A screen printing device may be, for example, a typical device including a screen printing plate, a squeegee, and other components. The screen printing plate includes a mesh transmitting the adhesive and a mask member disposed on the mesh. The mask member includes a photosensitive emulsion, for example, and has opening portions corresponding to an application pattern of the adhesive. In screen printing, the squeegee is slid on the screen printing plate on which the adhesive is placed to discharge the adhesive through the opening portions for printing the adhesive in the target locations on the light receiving face or the back face. Further, after completion of application of the adhesive on one of the opposite faces of the solar cell 11 facing upward, the solar cell 11 may be reversed by a reversing device to perform application of the adhesive on the other face facing upward.

Subsequently, in the back face wiring material disposing step S4 (FIG. 3), as illustrated in FIG. 4(c), the back face wiring materials 15 are disposed along the first direction Y over the back face (lower side in FIG. 4(c)) of the solar cell 11 on which the adhesive 30 (FIG. 5) is applied. FIG. 4(b) illustrates a plurality of wiring materials 15 disposed, by suction, on the plurality of plates 42 on the lower stage 41b. FIG. 4(c) illustrates the solar cell 11 disposed on the wiring materials 15 of the back face that is a lower side face of the solar cell 11 such that the back face wiring materials 15 are superposed on the third adhesion regions 35 (FIG. 6) and the fourth adhesion regions 37 (FIG. 6). Prior to attaching of the solar cell 11 to the wiring materials 15, cleaning or reforming may be applied to the surface of the wiring materials 15. The cleaning and reforming may include ozone cleaning and plasma treatment, for example.

In the light receiving face wiring material disposing step S5 (FIG. 3), as illustrated in FIG. 4(d), the light receiving face wiring materials 15 are placed along the first direction Y over the light receiving face (upper side in FIG. 4(d)) of the solar cell 11 on which the adhesive 30 (FIG. 5) is applied. FIG. 4(d) illustrates a plurality of wiring materials 15 disposed, by suction, on the plurality of plates 45 on the upper stage 44. The plurality of light receiving face wiring materials 15 are disposed on the solar cell 11 so as to be superposed on the first adhesion regions 31 (FIGs. 5 and 6) and the second adhesion regions 33 (FIGs. 5 and 6) on the light receiving face of the solar cell 11. In this state, the lower stage 41 and the upper stage 44 together sandwich the solar cell 11 and the back face and light receiving face wiring materials 15 to temporarily pressure-bond the back face wiring materials 15 and light receiving face wiring materials 15 onto the solar cell 11.

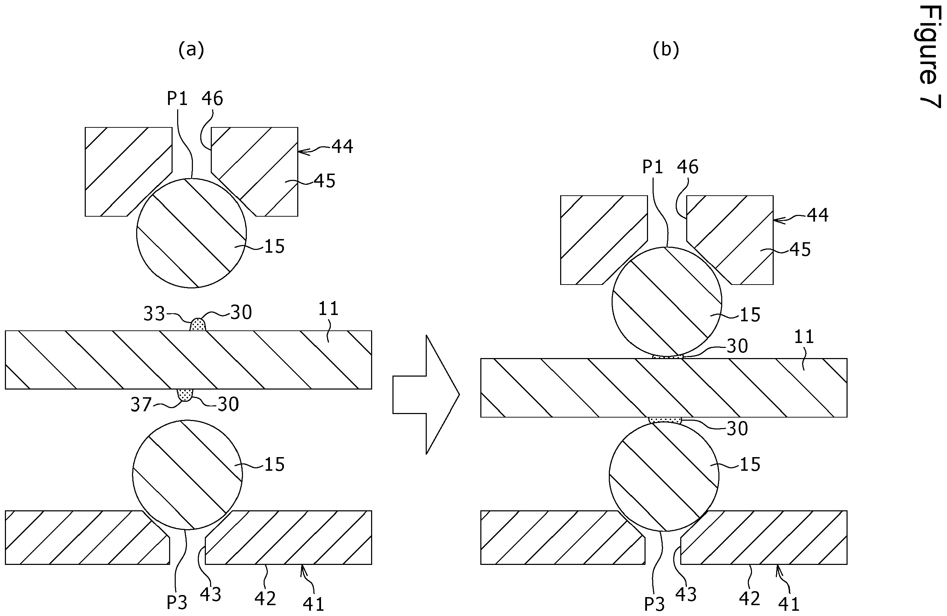

FIG. 6 is a diagram corresponding to the C-C cross section in FIG. 5(b), illustrating a method of disposing the wiring materials 15 on the respective opposite faces of the solar cell 11 on which the adhesive 30 is applied, in the wiring material fixing step in FIG. 3. FIG. 7 is a diagram corresponding to the D-D cross section in FIG. 5(b), illustrating the method of disposing the wiring materials 15 on the respective opposite faces of the solar cell 11 on which the adhesive 30 is applied in the wiring material fixing step in FIG. 3.

FIG. 6 shows the wiring material 15 in an exaggerated manner to have a larger diameter than the actual diameter in relation to other components. While FIG. 7 indicates the suction hole 46 of the upper stage 44 and the suction hole 43 of the lower stage 41 located at the same position in the longitudinal direction of the wiring material 15, the suction hole 46 of the upper stage 44 and the suction hole 43 of the lower stage 41 are actually located at different positions in the longitudinal direction of the wiring material 15, as illustrated in FIG. 6(b). However, the suction hole 46 of the upper stage 44 and the suction hole 43 of the lower stage 41 may be located at the same position in the longitudinal direction of the wiring material 15.

As illustrated in FIG. 6(b), in a state wherein the upper stage 44 and the lower stage 41 sandwich the solar cell 11, and both the light receiving face wiring materials 15 and the back face wiring materials 15, portions of the wiring material 15 indicated with P1 that are holder regions corresponding to the suction holes 46 of the upper stage 44, and portions of the wiring material 15 indicated with P2 that are non-holder regions corresponding to regions different from the suction holes 46 of the upper stage 44, are alternately arranged along the longitudinal direction of the wiring material 15 or the first direction. Further, portions of the wiring material 15 indicated with P3 that are holder regions corresponding to the suction holes 43 of the lower stage 41, and portions of the wiring material 15 indicated with P4 that are non-holder regions corresponding to regions different from the suction holes 43 of the lower stage 41, are alternately arranged along the longitudinal direction of the wiring material 15 or the first direction. In the back face wiring material disposing step S4 (FIG. 3), in a state wherein the lower stage 41 sucks the wiring material 15 and is in contact with the holder regions P3 of the wiring material 15, that is, with inner portions of opening ends of the suction holes 43 being in contact with the holder regions P3, the back face wiring material 15 is disposed in the third adhesion regions 35 and the fourth adhesion regions 37 on the solar cell 11 such that the fourth adhesion regions 37 of the adhesive 30 overlap the holder regions P3 in a direction orthogonal to the longitudinal direction of the wiring material 15 (or the vertical direction in FIG.6).

Further, in the light receiving face wiring material disposing step S 5(FIG. 3), in a state wherein the upper stage 44 sucks the wiring material 15 and is in contact with the holder regions P1 of the wiring material 15, that is, with inner portions of opening ends of the suction holes 46 being in contact with the holder regions PI, the light receiving face wiring material 15 is disposed on the first adhesion regions 31 and the second adhesion regions 33 on the solar cell 11 such that the second adhesion regions 33 of the adhesive 30 overlap the holder regions P1 in a direction orthogonal to the longitudinal direction of the wiring material 15 (or the vertical direction in FIG.6).

Consequently, as illustrated in FIGs. 7(a) and 7(b), the light receiving face (upper side in FIG. 7) wiring material 15 is disposed on the first and second adhesion regions 31 and 33, and the back face (lower side in FIG. 7) wiring material 15 is disposed on the third and fourth adhesion regions 35 and 37 such that the second adhesion region 33 of the adhesive 30 and the holder region P1 of the light receiving face wiring material 15 overlap, and the fourth adhesion region 37 of the adhesive 30 and the holder region P3 of the back face wiring material 15 overlap. The second adhesion region 33 and the fourth adhesion region 37 each include less adhesive 30 than the first adhesion region 31 and the third adhesion region 35, respectively. This prevents the adhesive 30 that is pressed by the light receiving face wiring material 15 or the back face wiring material 15, and is spread out, from flowing into the upper side or lower side of the wiring material 15, adjacent to the holder, and reaching the suction holes 46 and 43 of the upper stage 44 and the lower stage 41, respectively. This configuration therefore reduces contamination in each of the stages 44 and 41 and reduces the frequency of cleaning of the manufacturing device to thereby prevent removal of the wiring materials 15 by preventing a reduction in the suction power of the stages 41 and 44.

In the above example, the wiring materials 15 are temporarily pressure-bonded to each of the opposite faces of a single solar cell 11. This temporary pressure-bonding process is repeated for a plurality of pairs of adjacent solar cells 11. Specifically, a first end of the light receiving face wiring material 15 that has been temporarily pressure-bonded in the previous wiring material disposing step is pressure-bonded to the back face of the solar cell 11 to be temporarily pressure bonded the next, and the light receiving face wiring material 15 is then temporarily pressure-bonded to the light receiving face of the solar cell 11. This series of processes is to be repeated, thereby producing the string 90 (FIG. 8) of a plurality of solar cells 11 coupled together with the wiring materials 15.

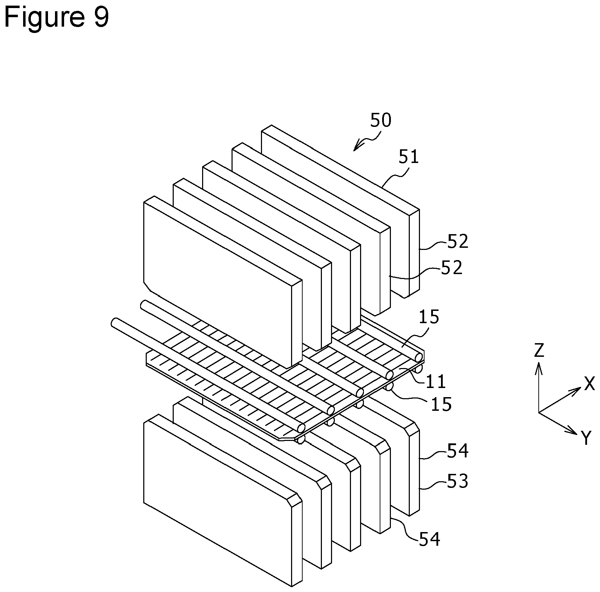

Referring now to FIG. 8 to FIG. 10, the first attaching step S6 (FIG. 3) and the second attaching step S7 (FIG. 3) will be described. FIG. 8 schematically illustrates a state immediately before heating and pressing two solar cells 11 in directions from both the respective opposite sides by first and second heating and pressing devices 50 and 56, respectively, in the first attaching step S6 and the second attaching step S7 in FIG. 3. FIG. 9 is an enlarged perspective view of a portion E in FIG. 8. FIG. 10 schematically illustrates a state in which two solar cells 11 are being heated and pressed in directions from both the respective opposite sides by the first and second heating and pressing devices 50 and 56, respectively, in the first attaching step S6 and the second attaching step S7 in FIG.3.

As illustrated in FIG. 8 to FIG. 10, the first attaching step S6 is performed by the first heating and pressing device 50, and the second attaching step S7 is performed by the second heating and pressing device 56. Specifically, the string 90 produced in the wiring material disposing step is moved horizontally to move one solar cell portion of the solar cells 11 in the string 90 to the first heating and pressing device 50 and thereafter further move the one solar cell 11 portion to the second heating and pressing device 56.

As illustrated in FIG. 9, the first heating and pressing device 50 basically has a configuration similar to the configuration including the lower stage 41, the upper stage 44, and a mover to move the plates 45 of the upper stage 44 illustrated in FIG. 4(d), but including no suction device. More specifically, the first heating and pressing device 50 includes an upper stage 51 having a plurality of plates 52 arranged at intervals along the width direction X, a lower stage 53 having a plurality of plates 54 arranged at intervals along the width direction X, and a mover (not shown) that vertically moves the plurality of plates 52 and 54 of the upper stage 51 and the lower stage 53, respectively. The plates 52 and 54 of the upper stage 51 and the lower stage 53 sandwich the solar cell 11 and the light receiving face wiring materials 15 and the back face wiring materials 15, and perform both heating and pressing. The plurality of plates 52 and 54 contain a heater and are heated to a predetermined high temperature. In the first attaching step S6, as illustrated in FIG. 8, the plates 52 and 54 of the upper stage 51 and the lower stage 53 sandwich the solar cell 11 to which the wiring materials 15 are temporarily pressure-bonded, from both above and below to heat and press the solar cell 11 for a predetermined time and at a predetermined temperature at which the adhesive is cured. The solar cell 11 is then moved from the space between the upper stage 51 and the lower stage 53 of the first heating and pressing device 50 toward the second heating and pressing device 56.

The second heating and pressing device 56, similar to the first heating and pressing device 50, includes an upper stage 57, a lower stage 58, and a mover. In the second attaching step S7, similar to the first attaching step S6, the plurality of plates of the upper stage 57 and the lower stage 58 sandwich the solar cell 11 and the light receiving face wiring materials 15 and the back face wiring materials 15 to perform both heating and pressing for a predetermined time and at a predetermined temperature.

In the above configuration, the bonding strength between the solar cell 11 and the light receiving face wiring material 15 prior to the second attaching step is smaller than the bonding strength between the solar cell 11 and the light receiving face wiring material 15 after the second attaching step. Further, the bonding strength between the solar cell 11 and the back face wiring material 15 prior to the second attaching step is also smaller than the bonding strength between the solar cell 11 and the back face wiring material 15 after the second attaching step. The predetermined times for which the solar cell 11 and the wiring materials 15 on the opposite faces are heated and pressed may be the same in the first attaching step and the second attaching step. As the entire pressing time is a sum of the pressing time in the first attaching step and the pressing time in the second attaching step, the bonding strength of the light receiving face wiring material 15 after the second attaching step is higher than the bonding strength of the light receiving face wiring material 15 after the first attaching step and prior to the second attaching step. Further, the bonding strength of the back face wiring material 15 after the second attaching step is higher than the bonding strength of the back face wiring material 15 after the first attaching step and prior to the second attaching step. In the above example, in the first attaching step and the second attaching step, the upper stage and the lower stage sandwich the solar cell 11 and the light receiving face wiring materials 15 and the back face wiring materials 15 for both heating and pressing. However, in each attaching step, only one of heating or pressing may be performed on the solar cell 11 having the wiring materials 15 disposed on both the light receiving face and the back face, from both sides.

The adhesive applying step and the wiring material fixing step described above may be performed by integrally controlling, with a controller (not shown), the operation of each of the components of the manufacturing device for the solar cell module 10. The functions of the controller may be divided into a plurality of pieces of hardware. Further, all of the adhesive applying steps may be automatically performed using the functions of the controller, or part of the steps may be performed by human operations.

After the wiring material fixing step described above, the components of the solar cell module 10 including the string 90 are stacked for thermocompression bonding. This process is referred to as a lamination step. In the lamination step, a first resin film forming the filler 14 is disposed over the protective member 12, and the string 90 is further disposed over the first resin film. On the string 90, a second resin film forming the filler 14 is disposed, and the protective member 13 is further disposed on the second resin film. Lamination is performed while heating the films at temperatures at which the films are melted, and pressurizing the films. Consequently, a structure including the string 90 sealed with the filler 14 can be obtained. Finally, a frame and a terminal box, for example, are attached, thereby manufacturing the solar cell module 10.

This manufacturing method optimizes the application state of the adhesive 47 to reduce adhesion of the adhesive 30 to the holder that holds the wiring materials 15. This reduces contamination of the holder and reduces the frequency of cleaning of the manufacturing device, thereby preventing a decrease in the suction force of the holder and preventing removal of the wiring material 15.

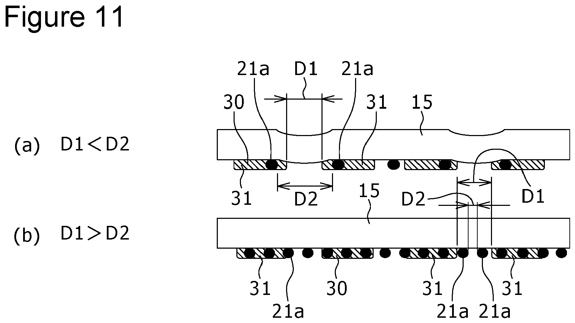

In the adhesive applying step, the adhesive 30 is applied to each of the first adhesion regions 31 on the light receiving face across the plurality of finger electrodes 22a, and assuming that the interval between the adhesives 30 in adjacent first adhesion regions 31 is D1, and the interval between adjacent finger electrodes 22a including one finger electrode 22a of the two adhesives 30 is D2, the relationship of D1 > D2 is satisfied. This configuration prevents adhesion of the adhesive 30 to the suction holes 43 of the lower stage 41 serving as the holder. This will be described with reference to FIG. 11.

FIG. 11 is a diagram for explaining an advantage of the embodiment, showing a reference example (a) in which the interval D1 between the adhesives 30 in the adjacent first adhesion regions 31 of the solar cell 11 is smaller than the interval D2 of the adjacent finger electrodes 22a, and the embodiment (b) in which the interval D1 is larger than the interval D2. FIG. 11 is a schematic view corresponding to the C-C cross section of FIG. 5(b). FIGs. 11(a) and 11(b) do not show the adhesive 30 in the second adhesion regions 33.

In the reference example illustrated in FIG. 11(a), the interval D2 between the adjacent finger electrodes 22a is larger than the interval D1 between the adhesives 30 in the adjacent first adhesion regions 31. In this reference example, when a force for temporary pressure-bonding is applied to the wiring material 15 from the upper stage 44 toward the solar cell 11 on the lower side in FIG. 11(a), the force that supports the wiring material 15 between the adhesives 30 in the first adhesion regions 31 is small. This causes the wiring material 15 to warp toward the solar cell 11 (downward in FIG. 11(a)) between the adhesives, which may further cause the adhesive 30 in first adhesion region 31 and the second adhesion region to flow around the wiring material 15 and adhere to the suction holes of the upper stage 44.

In the embodiment illustrated in FIG. 5(c) and FIG. 11(b), the interval D2 between the finger electrode 22a is smaller than the interval D1 between the adhesives 30 in the adjacent first adhesion regions 31. This configuration, with the finger electrodes 22a, supports the wiring material 15 between the adhesives 30 in the first adhesion regions 31 when the force for temporary pressure bonding is applied to the wiring material 15 from the upper stage 44 downward in FIG. 11(b) toward the solar cell 11, thereby preventing the wiring material 15 from warping toward the solar cell 11 (downward in FIG. 11(b)) between the adhesives 30. This increases an advantage of preventing the adhesive 30 in the first adhesion region 31 and the second adhesion region from flowing around the wiring material 15 and adhering to the suction holes of the upper stage 44.

Referring further to FIG. 5(c), in the embodiment, assuming that the width of the light receiving face wiring material 15 is D3, and the major axis or the maximum width of the suction hole 46 (the diameter of the suction hole 46 having a perfect circle) that suctions the light receiving face wiring material 15 of the upper stage 44 is D4, with regard to the longitudinal direction of the finger electrodes 22a, the relationship of D1 > D2 > D3 > D4 is satisfied. This configuration increases the advantage of preventing the adhesive 30 from flowing around the wiring material 15 toward the suction hole 46 and adhering to the suction hole 46, compared to the configuration with the width D3 of the wiring material 15 being smaller than the major axis D4 of the suction hole 46.

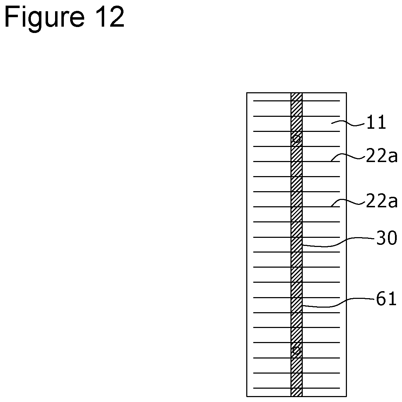

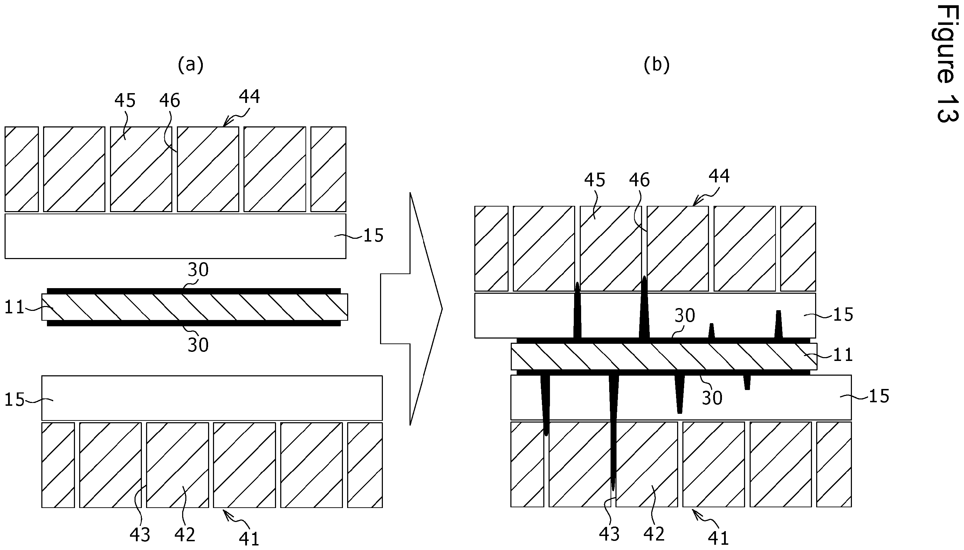

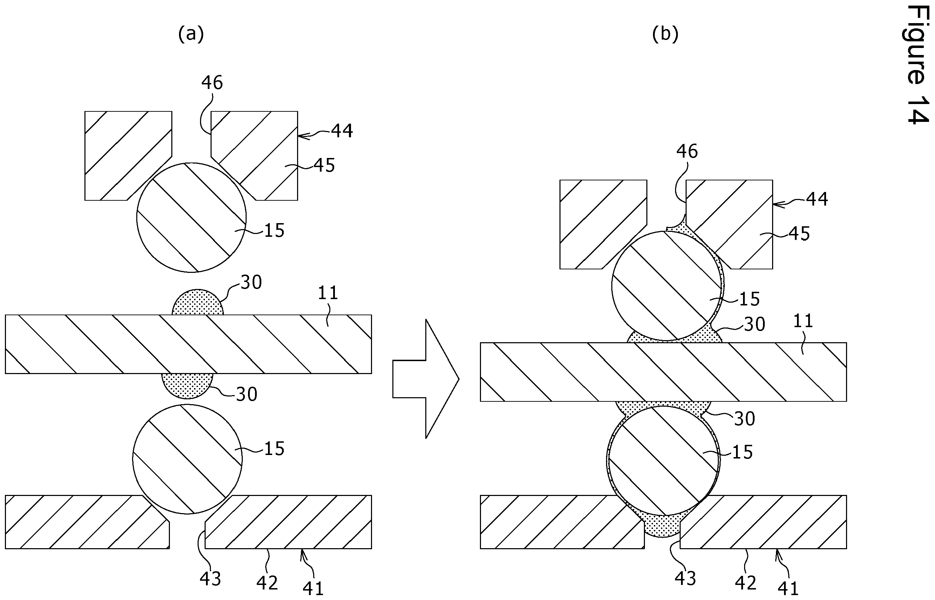

FIG. 12 illustrates a comparative example of a solar cell module manufacturing method, corresponding to FIG. 5(b). FIG. 13 illustrates a comparative example solar cell module manufacturing method, corresponding to FIG. 6. FIG. 14 illustrates a comparative example solar cell module manufacturing method, corresponding to FIG. 7.

As illustrated in FIG. 12, the comparative example includes a light receiving face adhesive applying step and a back face adhesive applying step, in place of the first and second regions adhesive applying step and the third and fourth regions adhesive applying step of the embodiment. In the light receiving face adhesive applying step, the adhesive 30 is uniformly applied linearly on the light receiving face of the solar cell 11 along the first direction substantially orthogonal to the finger electrodes 22a (vertical direction in FIG. 12) to thereby form a light receiving face application portion 61. In the light receiving face adhesive applying step, a plurality of light receiving face application portions 61 are formed parallel to each other at intervals along the second direction (horizontal direction in FIG. 12) orthogonal to the first direction. The width of the light receiving face application portion 61 in the second direction is the same as the width of the adhesive 30 applied in the first adhesion region 31 in the embodiment illustrated in FIG. 5(b), along the section direction (horizontal direction in FIG. 5(b)). In the light receiving face wiring material disposing step, a plurality of light receiving face wiring materials are arranged along the respective light receiving face application portions 61 and are temporarily pressure bonded to the light receiving face of the solar cell 11 with the light receiving face application portions 61.

In the back face adhesive applying step, similar to the light receiving face adhesive applying step, the adhesive is uniformly applied linearly on the back face of the solar cell 11 along the first direction substantially orthogonal to the finger electrodes to thereby form a back face application portion (not shown). In the back face adhesive applying step, a plurality of back face application portions are formed parallel to each other at intervals along the second direction orthogonal to the first direction. The width of the back face application portion in the second direction is the same as the width of the adhesive 30 applied to the third adhesion region 35 in the embodiment, along the second direction. In the back face wiring material disposing step, a plurality of back face wiring materials are arranged along the respective back face application portions and are temporarily pressure bonded to the back face of the solar cell 11 through the back face application portions.

As illustrated in FIG. 13 and FIG. 14, in the comparative example, the wiring materials 15 are held by the lower stage 41 and the upper stage 44, respectively, and are temporarily pressure-bonded to the respective opposite faces of the solar cell 11. Contrary to the embodiment illustrated in FIG. 6 and FIG. 7, in the comparative example, a large amount of adhesive 30 is applied to portions of the respective stages 41 and 44 where the suction holes 43 and 46 and the wiring materials 15 overlap in the direction (the vertical direction in FIG. 13) orthogonal to the longitudinal direction of the wiring materials 15. This configuration may cause the adhesive 30 to flow around the wiring material 15 toward the respective stages 41 and 44 and enter and adhere to the suction holes 43 and 46 of the respective stages 41 and 44 when the wiring material 15 is pressed against the adhesive 30, as illustrated in FIG. 13(b) and FIG. 14(b). In contrast, in the embodiment illustrated in FIG. 1 to FIG. 10, the second adhesion region 33 having less adhesive 30 than the first adhesion region 31 and the fourth adhesion region 37 having less adhesive 30 than the third adhesion region 35 are disposed in portions of the respective stages 41 and 44 overlapping the suction holes 43 and 46, respectively. This configuration prevents the adhesive 30 from flowing around the wiring material 15 toward the respective stages 41 and 44 to thereby prevent adhesion of the adhesive 30 to the suction holes 43 and 46 of the stages 41 and 44, respectively, when the wiring material 15 is pressed against the adhesive 30, as illustrated in FIG. 6(b) and FIG. 7(b). The embodiment thus prevents disadvantages caused in the comparative example.

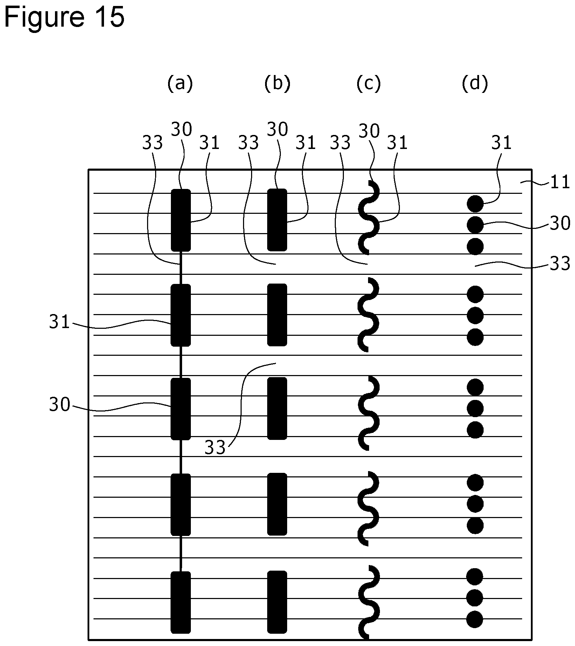

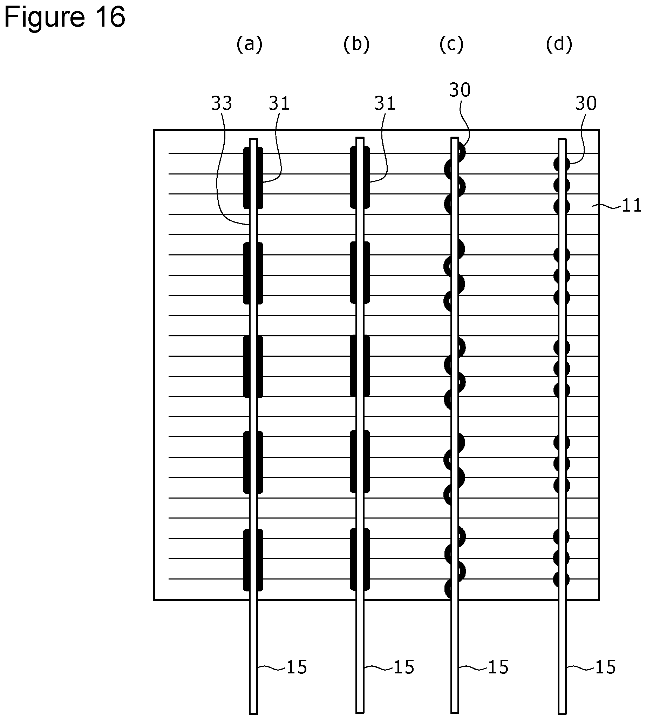

FIG. 15 illustrates application states of the adhesive 30 on the light receiving face of the solar cell 11 in four further examples of the embodiment of the present invention. FIG. 16 illustrates fixed states of the wiring material 15 on the light receiving face of the solar cell 11 in the four further examples of the embodiment of the present invention. In the present disclosure, the adhesive application state on the light receiving face and the back face of the solar cell 11 is not limited to the example illustrated in FIG. 5(b), and the application states in these four further examples illustrated in FIGs. 15(a) to 15(d), and FIG. 16(a) to 16(d), for example, may also be employed. In the examples illustrated in FIG. 15(a), and FIG. 16(a), each of the first adhesion regions 31 on the light receiving face are shorter than the first adhesion region 31 in the embodiment illustrated in FIG. 5(b). In the application states illustrated in FIG. 15(a) and FIG. 16(a), the length of the third adhesion region 35 on the back face may also be shorter, similar to the first adhesion region 31.

In the examples illustrated in FIG. 15(b) and FIG. 16(b), unlike the example in FIG. 5(b), the adhesive is not applied to each of the second adhesion regions 33 on the light receiving face. In the application states illustrated in FIG. 15(b) and FIG. 16(b), the adhesive is not similarly applied to each of the fourth adhesion regions 37 on the back face. As the adhesive applying steps, in place of the first and second regions adhesive applying step, a first adhesive applying step is performed in which the adhesive is applied to the first adhesion regions 31 but the adhesive is not applied to the second adhesion regions 33, and in place of the third and fourth region adhesive applying step, a third adhesive applying step is performed in which the adhesive is applied to the third adhesion regions 35 but is not applied to the fourth adhesion regions 37. A configuration in which the adhesive is not applied to only either the second adhesion region 33 or the fourth adhesion region 37 may be employed. This configuration further prevents the adhesive 30 from flowing around the wiring material 15 toward the holder when the wiring material 15 is pressed against the adhesive 30, thereby more reliably preventing adhesion of the adhesive 30 to the suction holes of the holder.

In the examples illustrated in FIG. 15(c) and FIG. 16(c), the adhesive 30 on the light receiving face has a winding curve shape when viewed from the direction orthogonal to the light receiving face. In the examples illustrated in FIG. 15(c) and FIG. 16(c), similar to the examples in FIG. 15(b) and FIG. 16(b), the adhesive is not applied to the second adhesion region 33. The adhesive application states of the third adhesion region 35 and the fourth adhesion region 37 on the back face are similar to those illustrated in FIG. 15(c) and FIG. 16(c).

In the examples illustrated in FIG. 15(d) and FIG. 16(d), in the first adhesion regions 31 on the light receiving face, a plurality of round dot-shape adhesives 30 are spaced along the first direction (vertical direction in FIG. 15(d) and FIG. 16(d)) at small intervals that are smaller than the intervals between the adjacent first adhesion regions 31. In the examples illustrated in FIG. 15(d) and FIG. 16(d), similar to the examples in FIG. 15(b) and FIG. 16(b), the adhesive is not applied to the second adhesion regions 33. The adhesion application states of the third adhesion regions 35 and the fourth adhesion regions 37 on the back face are similar to those in FIG. 15(d) and FIG. 16(d). As described above, in the first adhesion regions 31 and the third adhesion regions 35, adhesive 30 may be applied intermittently along the first direction. Similarly, in the second adhesion regions 33 and the fourth adhesion regions 37, the adhesive may be intermittently applied along the first direction, although not shown in the drawings. Further, in each of the first adhesion regions 31 in the examples illustrated in FIG. 5(b) and FIGs. 15(a) and 15(b), the adhesive may have different widths along the second direction at two or more different locations along the first direction.

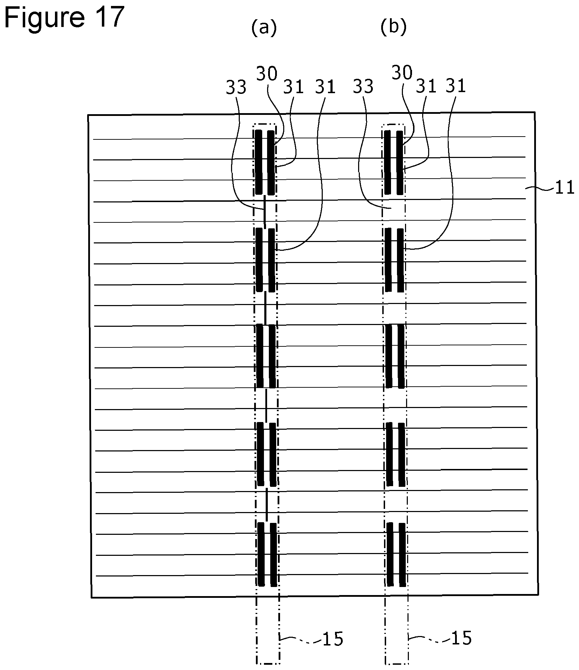

FIG. 17 illustrates application states of the adhesive 30 on the light receiving face of the solar cell 11 in two further examples of the embodiment of the present invention. The application states of the adhesive 30 in FIG. 17(a) or FIG. 17(b) may be used on the light receiving face and the back face of the solar cell 11. In the example illustrated in FIG. 17(a), the adhesive 30 is applied in two parallel lines spaced from each other in the second direction (horizontal direction in FIG. 17(a)) in the first adhesion region 31 on the light receiving face, and the adhesive 30 is applied in the second adhesion region 33 in a single line between the two linear adhesives 30 in the first adhesion region 31. The adhesion application states in the third adhesion region 35 and the fourth adhesion region 37 on the back face are similar to those in the example illustrated in FIG. 17(a).

In the example illustrated in FIG. 17(b), the adhesive is not applied to the second adhesion region 33 in the adhesion state illustrated in FIG. 17(a). The adhesion application states in the third adhesion region 35 and the fourth adhesion region 37 on the back face are similar to those illustrated in FIG. 17(b).

The wiring material fixing steps illustrated in FIG. 8 and FIG. 10 may further include, in addition to the first attaching step and the second attaching step, a third attaching step of heating and pressing the solar cells 11 and the wiring materials 15 with the upper stage 71 and the lower stage 72, as indicated with parentheses in FIG. 8 and FIG. 10.

Further, in the manufacturing method in FIG. 3, the light receiving face wiring material disposing step may be performed prior to the back face wiring material disposing step. In the manufacturing method of the disclosure, the attaching step may be performed only once if temporary pressure bonding of the wiring material 15 to the solar cell 11 is not performed.

### REFERENCE SIGNS LIST

10 solar cell module, 11 solar cell, 12, 13 protective member, 14 filler, 15 wiring material, 20 photoelectric converter, 21a, 21b transparent conductive layer, 22a, 22b finger electrode, 30 adhesive, 31 first adhesion region, 33 second adhesion region, 35 third adhesion region, 37 fourth adhesion region, 40 wiring material connecting system, 41 lower stage, 42 plate, 43 suction hole, 44 upper stage, 45 plate, 46 suction hole, 50 first heating and pressing device, 56 second heating and pressing device, 61 light receiving face application portion.

## Claims

1. A solar cell module manufacturing method comprising the step of:
preparing a solar cell having a light receiving face and a back face and including current collecting electrodes on each of the light receiving face and the back face;
applying an adhesive in first adhesion regions on the light receiving face of the solar cell such that the first adhesion regions and second adhesion regions are alternatively arranged along a first direction, and applying an adhesive in third adhesion regions on the back face of the solar cell such that the third adhesion regions and fourth adhesion regions are alternatively arranged along the first direction;
disposing light receiving face wiring materials over the light receiving face of the solar cell to which the adhesive is applied, along the first direction;
disposing back face wiring materials over the back face of the solar cell to which the adhesive is applied, along the first direction; and
heating or pressing the solar cell on which the light receiving face wiring materials and the back face wiring materials are disposed in directions from both the light receiving face and the back face to attach the light receiving face wiring materials and the back face wiring materials, wherein
the light receiving face wiring materials each include holder regions and non-holder regions arranged along the first direction,
the step of disposing the light receiving face wiring materials comprises:
bringing a first holder into contact with the holder regions of the light receiving face wiring materials, and
in this state, disposing the light receiving face wiring materials on the first adhesion regions and the second adhesion regions on the solar cell such that the second adhesion regions and the holder regions overlap,
the back face wiring materials each include holder regions and non-holder regions arranged along the first direction, and
the step of disposing the back face wiring materials comprises:
bringing a second holder into contact with the holder regions of the back face wiring materials, and
in this state, disposing the back face wiring materials on the third adhesion regions and the fourth adhesion regions on the solar cell such that the fourth adhesion regions and the holder regions overlap.

2. The solar cell module manufacturing method according to claim 1, wherein
the step of applying the adhesive further comprises the steps of:
applying the adhesive to the second adhesion regions in an amount that is less than an amount of the adhesive to be applied to the first adhesion regions; and
applying the adhesive to the fourth adhesion regions in an amount that is less than an amount of the adhesive to be applied to the third adhesion regions.

3. The solar cell module manufacturing method according to claim 1, wherein
in the step of applying the adhesive, no adhesive is applied to the second adhesion regions or the fourth adhesion regions.

4. The solar cell module manufacturing method according to any one of claims 1 to 3, wherein
the step of disposing the light receiving face wiring materials comprises disposing the light receiving face wiring materials such that the second adhesion regions and the holder regions overlap, with the first holder having a mechanism that sucks outside air, sucking the light receiving face wiring materials, and
the step of disposing the back face wiring materials comprises disposing the back face wiring materials such that the fourth adhesion regions and the holder regions overlap, with the second holder having a mechanism that sucks outside air sucking the back face wiring materials.

5. The solar cell module manufacturing method according to any one of claims 1 to 4, wherein
the light receiving face wiring materials and the back face wiring materials have a substantially circular cross section.

6. The solar cell module manufacturing method according to any one of claims 1 to 5, wherein
the step of applying the adhesive is performed with any one of screen printing, a dispenser, or spray.

7. The solar cell module manufacturing method according to any one of claims 1 to 6, wherein
the step of applying the adhesive comprises applying the adhesive to each of the first adhesion regions on the light receiving face so as to extend across the current collecting electrodes intersecting the wiring materials, and
assuming that an interval of the adhesives on the first adhesion regions adjacent to each other in the first direction is D1, and an interval of the current collecting electrodes adjacent to each other, including one of the current collecting electrodes that is disposed between the two adjacent adhesives, is D2, a relationship of D1 > D2 is satisfied.

8. The solar cell module manufacturing method according to claim 7, wherein
assuming that a width of the light receiving face wiring materials along a longitudinal direction of the current collecting electrodes is D3, and a maximum width of suction holes of the first holder that suck the light receiving face wiring materials is D4, a relationship of D1 > D2 > D3 > D4 is satisfied.

9. The solar cell module manufacturing method according to any one of claims 1 to 8, wherein
the step of attaching the light receiving face wiring materials and the back face wiring materials further comprises:
after the step of disposing the light receiving face wiring materials and the step of disposing the back face wiring materials, a first attaching step of heating or pressing the solar cell on which the wiring materials are disposed in directions from both the light receiving face and the back face; and
after the first attaching step, a second attaching step of heating or pressing the solar cell on which the wiring materials are disposed in directions from both the light receiving face and the back face, and
a bonding strength between the solar cell and the light receiving face wiring materials prior to the second attaching step is smaller than a bonding strength between the solar cell and the light receiving face wiring materials after the second attaching step.
